# EUROPÄISCHE PATENTSCHRIFT

(11) **EP 3 224 934 B1**
(45) Veröffentlichungstag und Bekanntmachung des Hinweises auf die Patenterteilung: **23.01.2019**
(21) Anmeldenummer: 15771579.8
(22) Anmeldetag: 29.09.2015
(51) Int. Cl.: H03K 17/12, H02M 1/32, H02M 1/088

(54) **VERFAHREN UND VORRICHTUNG ZUM ANSTEUERN PARALLEL GESCHALTETER LEISTUNGSHALBLEITERSCHALTER**
METHOD AND DEVICE FOR CONTROLLING POWER SEMICONDUCTOR SWITCHES CONNECTED IN PARALLEL
PROCÉDÉ ET DISPOSITIF DE COMMANDE D'INTERRUPTEURS À SEMI-CONDUCTEURS DE PUISSANCE MONTÉS EN PARALLÈLE

(30) Priorität: 26.11.2014 DE 102014224169
(43) Veröffentlichungstag der Anmeldung: 04.10.2017
(73) Patentinhaber: Robert Bosch GmbH, 70442 Stuttgart (DE)
(72) Erfinder: BUTZMANN, Stefan, 58579 Schalksmühle (DE); TAUFER, Peter, 71272 Renningen (DE); ECKERT, Bernd, 71665 Vaihingen An Der Enz (DE)
(86) Internationale Anmeldenummer: PCT/EP2015/072303
(87) Internationale Veröffentlichungsnummer: WO 2016/082984

(56) Entgegenhaltungen:
- EP-A1- 2 445 110
- WO-A1-2006/104430
- JP-A- S55 136 868
- US-A1- 2013 176 752
- US-A1- 2013 300 400
- US-A1- 2014 159 630

## Beschreibung

Die Erfindung betrifft ein Verfahren und ein Steuergerät zum Ansteuern parallel geschalteter Leistungshalbleiterschalter. Ferner betrifft die Erfindung ein elektrisches System mit dem Steuergerät, ein Computerprogramm zur Durchführung dieses Verfahrens, sowie ein elektronisches Speichermedium.

### Stand der Technik

die Druckschrift JP S 55 136868 A offenbart eine Schaltungsanordnung mit zwei parallel angeordneten Transistoren. Die Ansteuerung der beiden parallel angeordneten Transistoren kann hierbei gemäß dem dargestellten Timing-Diagramm alternierend erfolgen.

Zum Betreiben elektrischer Antriebe werden üblicherweise Wechselrichter eingesetzt, die die elektrische Energie aus einer Gleichspannungsquelle, z. B. einer Batterie, in eine Wechselspannung umwandeln, um eine elektrische Maschine, z.B. eine Asynchronmaschine, mit Wechselspannung bzw. Wechselstrom zu versorgen. Der Wechselrichter weist hierzu sogenannte Halbbrücken auf. Diese Halbbrücken weisen Leistungshalbleiterschalter auf, mittels denen der Gleichstrom und die Gleichspannung getaktet geschaltet werden, so dass an den Ausgangsklemmen des Wechselrichters eine Wechselspannung und ein Wechselstrom entstehen. Für diese Leistungshalbleiterschalter sind Stromobergrenzen vorgegeben, bei deren Überschreitung die Leistungshalbleiterschalter irreversibel geschädigt werden. Wenn nun höhere Ströme für den Betrieb des elektrischen Antriebs benötigt werden, werden daher diese Leistungshalbleiterschalter in den Wechselrichtern parallel geschaltet. Aufgrund von Bauteiltoleranzen werden jedoch die Leistungshalbleiterschalter auch beim parallelen Betrieb unterschiedlich stark belastet, da die Leistungshalbleiterschalter nicht gleichzeitig einschalten und daher einer der Leistungshalbleiterschalter gegebenenfalls früher einschaltet als ein anderer. Der am schnellsten und sensitivsten schaltende Leistungshalbleiterschalter trägt somit einen größeren Teil der Einschalt-, Ausschalt- und Stromleitungsverluste. Der Stromfluss zwischen den Schaltern teilt sich folglich ungleich auf die Leistungshalbleiterschalter auf. Einzelne Leistungshalbleiterschalter werden stärker thermisch belastet als andere, altern schneller und fallen somit schneller aus. Der maximale Laststrom wird daher gegebenenfalls durch die thermische Kapazität einzelner Leistungshalbleiterschalter bestimmt und nicht durch deren gesamte Stromtragfähigkeit.

Neben den unterschiedlichen Schaltzeitpunkten der einzelnen parallel geschalteten Leistungshalbleiterschalter sind bei der Ansteuerung auch die Laufzeitunterschiede der Ansteuersignale zu berücksichtigen. Ein Verfahren zur Minimierung der Laufzeitunterschiede der Ansteuersignale bei der Ansteuerung parallel geschalteter Leistungshalbleiterschalter ist aus der WO 2011/120728 A2 bekannt.

Es besteht daher das Bedürfnis zum Betrieb parallel geschalteter Leistungshalbleiterschalter weitere Lösungen zu entwickeln, die eine gleichmäßige Belastung parallel geschalteter Leistungshalbleiterschalter ermöglichen. So wird verhindert, dass einzelne Leistungshalbleiterschalter überlastet werden und vorzeitig ausfallen. Somit erhöht sich auch die Robustheit des gesamten Systems, in dem die parallel geschalteten Leistungshalbleiterschalter betrieben werden.

### Offenbarung der Erfindung

Es wird ein Verfahren zum Ansteuern von mindestens zwei parallel geschalteten Leistungshalbleiterschaltern zum Schalten eines Gesamtstromes gemäß Patentanspruch 1 bereitgestellt.

Das Verfahren dient somit der Ansteuerung parallel geschalteter Leistungshalbleiterschalter zum, insbesondere getakteten, Schalten eines Gesamtstroms. Als Leistungshalbleiterschalter sind bipolare Transistoren mit einem isolierten Gate (IGBT), Feldeffekttransistoren wie MOSFET oder weitere übliche Leistungshalbleiterschalter einsetzbar. Üblicherweise weisen die Leistungshalbleiterschalter einen Gate-Anschluss auf. In Abhängigkeit des elektrischen Potentials an dem Gate-Anschluss schaltet ein Leistungshalbleiter, er stellt eine galvanische Verbindung zwischen dem Eingangsanschluss und dem Ausgangsanschluss her, dann ist der Leistungshalbleiterschalter geschlossen und befindet sich im Zustand Schließen. Oder der Leistungshalbleiterschalter trennt den Eingangsanschluss und den Ausgangsanschluss galvanisch voneinander, dann ist der Leistungshalbleiterschalter geöffnet und befindet sich im Zustand Öffnen. Weiter ist eine Ermittlungseinheit vorgesehen, die eingangsseitig ein gemeinsames Ansteuersignal zur Ansteuerung mindestens zweier parallel geschalteten Leistungshalbleiterschalter empfängt. Das gemeinsame Ansteuersignal weist die Zustände Öffnen oder Schließen auf. Mittels der Leistungshalbleiterschalter soll entsprechend eine galvanische Verbindung zwischen dem Eingangsanschluss und dem Ausgangsanschluss getrennt oder hergestellt werden. Die Ermittlungseinheit gibt hierzu ausgangsseitig mindestens zwei Einzelansteuersignale aus, die eine Ansteuerung der mindestens zwei Leistungshalbleiterschalter zu vorgebbaren, insbesondere unterschiedlichen, Zeitpunkten bewirkt. Hierzu weisen die Einzelansteuersignale ebenfalls die Zustände Öffnen oder Schließen auf. Diese Zustände werden von den mittels der Einzelansteuersignale angesteuerten Leistungshalbleiterschaltern umgesetzt. Die mindestens zwei Einzelansteuersignale werden von der Ermittlungseinheit in Abhängigkeit des gemeinsamen Ansteuersignals derart ermittelt, dass sie sich zumindest zeitweise unterscheiden. Somit erfolgt eine zumindest teilweise individuelle Ansteuerung und ein zumindest teilweises individuelles Schalten der einzelnen parallel geschalteten Leistungshalbleiter. Die parallel geschalteten Leistungshalbleiter schalten zumindest teilweise nicht entsprechend dem gemeinsamen Ansteuersignal zu einem gemeinsamen Zeitpunkt, sondern zu unterschiedlichen nacheinander liegenden Zeitpunkten. Insbesondere erfolgt ein individuelles Schalten in Zeitabschnitten, während denen das gemeinsame Ansteuersignal den Zustand Schließen aufweist. Dies ist möglich, da bereits ein geschlossener Leistungshalbleiterschalter genügt, um eine galvanische Verbindung entsprechend des Zustands Schließen des gemeinsamen Ansteuersignals zwischen Eingangsanschluss und Ausgangsanschluss zu schaffen. Um eine galvanische Trennung zwischen dem Eingangsanschluss und dem Ausgangsanschluss entsprechend des Zustands Öffnen des gemeinsamen Ansteuersignals zu schaffen, ist insbesondere ein Öffnen aller parallel geschalteten Leistungshalbleiterschalter notwendig.

Vorteilhaft wird somit ein Verfahren bereitgestellt, welches es ermöglicht, parallel geschaltete Leistungshalbleiterschalter bewusst zu unterschiedlichen Zeitpunkten zuzuschalten. Somit wird ermöglicht, Einschalt-, Ausschalt- und Stromleitungsverluste nicht willkürlich auf einen oder wenige der parallel geschalteten Leistungshalbleiterschalter zu verteilen, sondern durch voneinander unabhängige Ansteuerung, beispielsweise durch alternierende Ansteuerung, der unterschiedlichen Leistungshalbleiterschalter gezielt und gegebenenfalls gleichmäßig auf die parallel geschalteten Leistungshalbleiterschalter zu verteilen. Insbesondere können durch Auswahl und Abwechslung der zuerst schließenden oder öffnenden Leistungshalbleiter die Einschalt-und Ausschaltverluste gezielt auf die einzelnen Leistungshalbleiter verteilt werden. Durch Variation der zeitlichen Dauer der Zustände, insbesondere des Zustands Schließen, der Einzelansteuersignale, können die Stromleitungsverluste variiert werden. Somit wird ein Verfahren geschaffen, welches ein gleichmäßigeres Verteilen der Leistung auf parallel geschaltete Leistungshalbleiterschalter bei deren Betrieb ermöglicht, auch wenn die Leistungshalbleiterschalter aufgrund ihrer Bauteiltoleranzen oder ihrer unterschiedlichen Dimensionierung unterschiedlich schnell und sensitiv auf ein Ansteuersignal reagieren. Somit wird ein Betrieb einer Parallelschaltung von Leistungshalbleiterschaltern beispielsweise aus unterschiedlichen Chargen oder Wafern oder unterschiedlicher Baugrößen oder Leistungen ohne singuläre Überlastung eines Leistungshalbleiterschalters bei optimaler Ausnutzung der Leistungsfähigkeit aller Leistungshalbleiterschalter ermöglicht.

In einer Ausgestaltung der Erfindung erfolgt die Ermittlung der Einzelansteuersignale derart in Abhängigkeit des Ansteuersignals, dass während das Ansteuersignal den Zustand Schließen aufweist, mindestens ein erstes der Einzelansteuersignale den Zustand Öffnen aufweist. Und insbesondere mindestens ein zweites der Einzelansteuersignale den Zustand Schließen aufweist.

Das bedeutet, dass in Abhängigkeit des Ansteuersignals, welches den Zustand Schließen aufweist, nicht alle Leistungshalbleiterschalter parallel angesteuert und geschlossen sind, sondern mindestens ein erstes der Einzelansteuersignale den Zustand Öffnen aufweist und beispielsweise nur ein Einzelansteuersignal den Zustand Schließen aufweist. Der Gesamtstrom fließt somit nicht über alle Leistungshalbleiterschalter und verteilt sich somit auch nicht gleichmäßig über alle Leistungshalbleiterschalter, sondern wird gezielt über einen oder eine Untermenge der Leistungshalbleiterschalter geführt. Vorteilhaft treten die Einschalt-, Ausschalt- und Stromleitungsverluste auch in diesem Fall gezielt an dem einen oder der Untermenge der Leistungshalbleiterschalter auf.

In einer anderen Ausgestaltung der Erfindung erfolgt die Ermittlung der Einzelansteuersignale derart in Abhängigkeit des Ansteuersignals, dass während das Ansteuersignal den Zustand Öffnen aufweist, alle Einzelansteuersignale den Zustand Öffnen aufweisen und während das Ansteuersignal anschließend den Zustand Schließen aufweist, mindestens ein zweites Einzelansteuersignal den Zustand Öffnen aufweist. Und insbesondere mindestens ein erstes der Einzelansteuersignale den Zustand Schließen aufweist.

Dies bedeutet, dass bei dem Zustand Öffnen des gemeinsamen Ansteuersignals alle Einzelansteuersignale ebenfalls den Zustand Öffnen aufweisen und somit alle parallel geschalteten Leistungshalbleiterschalter öffnen. Bei einem erneutem Zustand Schließen des gemeinsamen Ansteuersignals weist gezielt mindestens ein zweites Einzelansteuersignale den Zustand Öffnen auf, sodass nun mindestens ein zweiter Leistungshalbleiterschalter geöffnet bleibt und nicht belastet wird. Der Gesamtstrom wird insbesondere, da mindestens ein erstes der Einzelansteuersignale den Zustand Schließen aufweist, zumindest teilweise von dem mindestens ersten Leistungshalbleiterschalter oder eine anderen Untermenge der Leistungshalbleiterschalter, vom Eingangsanschluss zum Ausgangsanschluss geführt.

Vorteilhaft wird damit erreicht, dass die Einschalt-, Ausschalt- und Stromleitungsverluste nicht immer von dem selben Leistungshalbleiterschalter oder derselben Untermenge der Leistungshalbleiterschalter getragen werden, sondern auf unterschiedliche Leistungshalbleiterschalter der parallel geschalteten Leistungshalbleiterschalter, im Idealfall gleichmäßig auf alle der parallel geschalteten Leistungshalbleiterschalter, verteilt wird.

In einer anderen Ausgestaltung der Erfindung erfolgt die Ermittlung der Einzelansteuersignale derart in Abhängigkeit des Ansteuersignals, dass bei aufeinanderfolgenden Zuständen Schließen des Ansteuersignals abwechselnd alternierend unterschiedliche Einzelansteuersignale die Zustände Öffnen aufweisen. Oder insbesondere dass bei aufeinanderfolgenden Zuständen Schließen des Ansteuersignals abwechselnd alternierend unterschiedliche Einzelansteuersignale die Zustände Schließen aufweisen. Die Auswahl der alternierenden Einzelansteuersignale erfolgt dabei insbesondere zufällig oder nach einer festen Reihenfolge.

Das bedeutet, dass die Einzelansteuersignale derart ermittelt werden, dass stets mindestens eines der Einzelansteuersignale den Zustand Öffnen aufweist, welches nicht bereits bei dem unmittelbar vorher anliegenden Zustand Schließen des gemeinsamen Ansteuersignals, den Zustand Öffnen aufwies. Insbesondere werden die Einzelansteuersignale derart ermittelt, dass stets mindestens eines der Einzelansteuersignale den Zustand Schließen aufweist, welches nicht bereits bei dem unmittelbar vorher anliegenden Zustand Schließen des gemeinsamen Ansteuersignals, den Zustand Schließen aufwies. Durch Vorgabe einer Reihenfolge bei der Auswahl der alternierenden Einzelansteuersignale erfolgt eine besonders gleichmäßige Belastung der Leistungshalbleiterschalter.

Vorteilhaft wird somit sichergestellt, dass alle Leistungshalbleiterschalter der parallel geschalteten Leistungshalbleiterschalter gleichmäßiger belastet werden.

Die Belastung eines mit dem Einzelansteuersignal verbundenen Leistungshalbleiterschalters, oder der Untermenge der parallel geschalteten Leistungshalbleiterschalter, wird ermittelt, indem ein Absolutwert oder auch beispielsweise ein Verlauf, beispielsweise der Temperatur eines Leistungshalbleiterschalters, ermittel wird. Ebenso lässt sich eine Belastung auch mittels einer Erfassung der Verlustleistung ermitteln, die beim Schalten und bei dem Betrieb der Leistungshalbleiterschalter auftritt. Auch aus der mittels des Leistungshalbleiterschalters übertragenen Energiemenge als Produkt des Stroms und der Spannung über der Zeit lässt sich eine Belastung des Leistungshalbleiterschalters ermitteln. Auch andere Größen können zur Ermittlung der Belastung kumuliert werden und als korrelierende Größe mit der Belastung oder Alterung des Leistungshalbleiterschalters berücksichtigt werden. Die Ermittlung eines Einzelansteuersignals kann ferner auch in Abhängigkeit einer kumulierten Belastung über der gesamten Betriebszeit eines oder einer Untermenge der parallel geschalteten Leistungshalbleiterschalter oder einer Alterung der parallel geschalteten Leistungshalbleiterschalter erfolgen, beispielsweise indem der integrierte Temperaturverlauf über der gesamten Betriebszeit eines oder einer Untermenge der parallel geschalteten Leistungshalbleiterschalter berücksichtigt wird.

Vorteilhaft wird somit ein Verfahren geschaffen, welches eine möglichst gleichmäßige Alterung der Leistungshalbleiterschalter ermöglicht, indem stets die am wenigsten belasteten Leistungshalbleiterschalter ausgewählt und mittels des entsprechend ermittelten Einzelansteuersignals für die Stromführung des Gesamtstroms vom Eingangsanschluss zum Ausgangsanschluss angesteuert und verwendet werden.

In einer weiteren Ausgestaltung der Erfindung weist ein Einzelansteuersignal den Zustand Schließen auf, wenn es einen Leistungshalbleiterschalter ansteuert, dessen Belastung geringer als ein vorgebbarer Belastungsschwellwert ist.

Dies bedeutet, dass Belastungsschwellwerte für die einzelnen Leistungshalbleiterschalter, oder einer Untermenge der parallel geschalteten Leistungshalbleiterschalter vorgegeben werden. Bei der Ermittlung eines Einzelansteuersignals wird zunächst überprüft, ob ein vorgegebener Belastungsschwellwert eines Leistungshalbleiterschalters überschritten ist. Wenn die Belastung eines Leistungshalbleiterschalters größer ist als der Belastungsschwellwert, wird das entsprechende Einzelansteuersignale derart ermittelt, dass es den Zustand Öffnen aufweist. Wenn ein Einzelansteuersignal den Zustand Schließen aufweist, steuert es einen Leistungshalbleiterschalter an, dessen Belastung geringer ist als der Belastungsschwellwert. Die Belastungsschwellwerte lassen sich aus experimentellen Temperaturmessungen an den Leistungshalbleiterschaltern oder auch anhand geeigneter Temperatur-/ Verlustleistungsmodellen bestimmen. Durch geeignete Variation der Dauer der Zustände Öffnen und Schließen der einzelnen Leistungshalbleiterschalter und durch gleichmäßigen Einsatz der Leistungshalbleiterschalter können diese gemäß ihrer Verlustleistungsgrenze betrieben werden. Selbst wenn nur noch ein Leistungshalbleiterschalter verfügbar ist, kann in einem Notlauf-Betrieb eine Stromführung mit reduzierter Leistungsfähigkeit dargestellt werden.

Vorteilhaft werden somit zu stark belastete Leistungshalbleiterschalter nicht mehr für die Stromführung des Gesamtstroms vom Eingangsanschluss zum Ausgangsanschluss vorgesehen. Eine Zerstörung eines Leistungshalbleiterschalters, welche mit einem Kurzschluss und damit mit einem Defekt des gesamten elektrischen Systems einhergehen kann, wird vermieden.

In einer anderen Ausgestaltung der Erfindung wird als Belastung eines Leistungshalbleiterschalters eine Temperatur, eine Verlustleistung, eine übertragene Energiemenge oder die Schalthäufigkeit des mit dem Einzelansteuersignal anzusteuernden Leistungshalbleiterschalters berücksichtigt.

Dies bedeutet, dass eine Belastung berücksichtigt wird, die während des Betriebs der parallel geschalteten Leistungshalbleiterschalter ermittelt wird. Beispielsweise sind dies die Temperatur eines Leistungshalbleiterschalters, die erfasste Verlustleistung, die beim Schalten und bei dem Betrieb der Leistungshalbleiterschalter auftritt, die übertragene Energiemenge als Produkt des Stroms und der Spannung über der Zeit oder die Schalthäufigkeit.

Vorteilhaft werden somit Beispiele für Belastungen eines Leistungshalbleiterschalters für das Verfahren zur Verfügung gestellt, die eine Ermittlung oder Auswahl der Einzelansteuersignale der Leistungshalbleiterschalter ermöglichen, mit denen ein zuverlässiger und betriebssicherer Betrieb der Leistungshalbleiterschalter ermöglicht wird.

In einer anderen Ausgestaltung der Erfindung wird die Funktionsfähigkeit der Leistungshalbleiterschalter bestimmt und wenn ein Einzelansteuersignal den Zustand Schließen aufweist, steuert es einen funktionsfähigen Leistungshalbleiterschalter an.

Das bedeutet, dass als defekt erkannte Leistungshalbleiterschalter der parallel geschalteten Leistungshalbleiterschalter nicht für die Stromführung des Gesamtstroms vom Eingangsanschluss zum Ausgangsanschluss verwendet werden. Es werden nur Einzelansteuersignale mit dem Zustand Schließen ausgegeben, die funktionsfähige Leistungshalbleiterschalter ansteuern.

Vorteilhaft wird somit ein betriebssicherer Betrieb des elektrischen Systems gewährleistet. Insbesondere wird ein Gesamtausfall vermieden, der durch sich gegebenenfalls bildende Kurzschlüsse hervorgerufen werden kann.

In einer anderen Ausgestaltung der Erfindung werden als parallel geschaltete Leistungshalbleiterschalter mindestens teilweise parallel geschaltete Leistungshalbleitermodule verwendet, wobei ein Leistungshalbleitermodul parallel geschaltete Leistungshalbleiterschalter umfasst.

Das bedeutet, dass statt einzelnen einzeln ansteuerbaren parallel geschalteten Leistungshalbleiterschaltern mindestens teilweise parallel geschaltete Leistungshalbleitermodule verwendet werden. Ein Leistungshalbleitermodul entspricht dabei einer Parallelschaltung mehrerer Leistungshalbleiterschalter, deren Eingangs-, Ausgangs und Ansteueranschlüsse jeweils zusammengeführt sind. Solche Leistungshalbleitermodule sind in verschiedenen Größen und Leistungsklassen bekannt und werden für die Stromführung und Unterbrechung höherer elektrischer Leistungen mittels eines Ansteuersignals verwendet.

Vorteilhaft wird somit ein Betrieb parallel geschalteter Leistungshalbleitermodule ermöglicht, bei dem die einzelnen Leistungshalbleitermodule ebenfalls gleichmäßiger belastet werden, als wenn alle Leistungshalbleitermodule mittels einem Ansteuersignal angesteuert werden und aufgrund ihrer Bauteiltoleranzen oder ihrer unterschiedlichen Dimensionierung unterschiedlich schnell und sensitiv auf ein Ansteuersignal reagieren. Es ergeben sich somit für den Betrieb der parallel geschalteten Leistungshalbleitermodule vergleichbare Vorteile wie für den Betrieb parallel geschalteter Leistungshalbleiterschalter.

Ferner wird ein Steuergerät zum Ansteuern von mindestens zwei parallel geschalteten Leistungshalbleiterschaltern zum Schalten eines Gesamtstroms gemäß Patentanspruch 8 bereitgestellt.

Die Ermittlungseinheit kann dabei insbesondere als Hardware ausgebildet sein, beispielsweise als Logikmodul, aber auch als reine Software zur Steuerung einer entsprechenden Hardware.

Das Steuergerät dient somit der Ansteuerung parallel geschalteter Leistungshalbleiterschalter zum, insbesondere getakteten, Schalten eines Gesamtstroms. Weiter ist eine Ermittlungseinheit vorgesehen, die eingangsseitig ein gemeinsames Ansteuersignal zur Ansteuerung mindestens zweier parallel geschalteten Leistungshalbleiterschalter empfängt. Das gemeinsame Ansteuersignal weist die Zustände Öffnen oder Schließen auf, welche von den Leistungshalbleiterschaltern zumindest teilweise umgesetzt werden sollen. Ausgangsseitig gibt die Ermittlungseinheit hierzu mindestens zwei Einzelansteuersignale aus zur Ansteuerung der mindestens zwei Leistungshalbleiterschalter zu vorgebbaren, insbesondere unterschiedlichen, Zeitpunkten. Hierzu weisen die Einzelansteuersignale ebenfalls die Zustände Öffnen oder Schließen auf. Diese Zustände werden von den mittels der Einzelansteuersignale angesteuerten Leistungshalbleiterschaltern umgesetzt. Die mindestens zwei Einzelansteuersignale werden von der Ermittlungseinheit in Abhängigkeit des gemeinsamen Ansteuersignals derart ermittelt, dass sie sich zumindest zeitweise unterscheiden. Somit erfolgt eine zumindest teilweise individuelle Ansteuerung und ein zumindest teilweises individuelles Schalten der einzelnen parallel geschalteten Leistungshalbleiter. Die parallel geschalteten Leistungshalbleiter schalten zumindest teilweise nicht entsprechend dem gemeinsamen Ansteuersignal zu einem gemeinsamen Zeitpunkt, sondern zu unterschiedlichen nacheinander liegenden Zeitpunkten. Insbesondere erfolgt ein individuelles Schalten in Zeitabschnitten, während denen das gemeinsame Ansteuersignal den Zustand Schließen aufweist. Dies ist möglich, da bereits ein geschlossener Leistungshalbleiterschalter genügt, um eine galvanische Verbindung entsprechend des Zustands Schließen des gemeinsamen Ansteuersignals zwischen Eingangsanschluss und Ausgangsanschluss zu schaffen. Um eine galvanische Trennung zwischen dem Eingangsanschluss und dem Ausgangsanschluss entsprechend des Zustands Öffnen des gemeinsamen Ansteuersignals zu schaffen, ist insbesondere ein Öffnen aller parallel geschalteten Leistungshalbleiterschalter notwendig.

Vorteilhaft wird somit ein Steuergerät bereitgestellt, welches es ermöglicht, parallel geschaltete Leistungshalbleiterschalter bewusst zu unterschiedlichen Zeitpunkten zuzuschalten. Somit wird ermöglicht, Einschalt-, Ausschalt- und Stromleitungsverluste nicht willkürlich auf einen oder wenige der parallel geschalteten Leistungshalbleiterschalter zu verteilen, sondern durch voneinander unabhängige Ansteuerung, beispielsweise durch alternierende Ansteuerung, der unterschiedlichen Leistungshalbleiterschalter gezielt und gegebenenfalls gleichmäßig auf die parallel geschalteten Leistungshalbleiterschalter zu verteilen. Somit wird eine Vorrichtung geschaffen, welche ein gleichmäßigeres Verteilen der Leistung auf parallel geschaltete Leistungshalbleiterschalter bei deren Betrieb ermöglicht, auch wenn die Leistungshalbleiterschalter aufgrund ihrer Bauteiltoleranzen oder ihrer unterschiedlichen Dimensionierung unterschiedlich schnell und sensitiv auf ein Ansteuersignal reagieren. Somit wird der Betrieb einer Parallelschaltung von Leistungshalbleiterschaltern beispielsweise aus unterschiedlichen Chargen oder Wafern oder unterschiedlicher Baugrößen oder Leistungen ohne singuläre Überlastung eines Leistungshalbleiterschalters bei optimaler Ausnutzung der Leistungsfähigkeit aller Leistungshalbleiterschalter ermöglicht.

Ferner wird ein elektrisches System bereitgestellt, welches ein oben beschriebenes Steuergerät und parallel geschaltete Leistungshalbleiterschalter zum Schalten eines Gesamtstroms innerhalb eines Fahrzeuges umfasst.

Somit wird ein elektrisches System bereitgestellt, welches den Anforderungen innerhalb eines Fahrzeuges genügt und eine hohe Betriebssicherheit parallel geschalteter Leistungshalbleiterschalter aufweist.

Vorteilhaft wird ein elektrisches System zu Verfügung gestellt, welches die gleichmäßige Alterung parallel geschalteter Leistungshalbleiterschalter und somit einen sicheren Betrieb des Fahrzeugs ermöglicht.

Ferner wird ein Computerprogramm bereitgestellt, das ausgebildet ist, alle Schritte eines der Verfahren nach einem der Ansprüche 1 bis 7 auszuführen.

Ferner wird ein elektronisches Speichermedium bereitgestellt, auf dem das beschriebene Computerprogramm gespeichert ist.

Es versteht sich, dass die Merkmale, Eigenschaften und Vorteile des erfindungsgemäßen Verfahrens entsprechend auf das erfindungsgemäße Steuergerät bzw. auf das elektrische System und umgekehrt zutreffen bzw. anwendbar sind.

Weitere Merkmale und Vorteile von Ausführungsformen der Erfindung ergeben sich aus der nachfolgenden Beschreibung mit Bezug auf die beigefügten Zeichnungen.

### Kurze Beschreibung der Zeichnungen

Im folgenden soll die Erfindung anhand einiger Figuren näher erläutert werden, dazu zeigen:
Figur 1
   ein elektrisches System mit einem Steuergerät in einer schematischen Darstellung.
Figur 2
   eine Darstellung der Ansteuersignale über der Zeit.
Figur 3
   ein Ablaufdiagramm für ein Verfahren zur Ansteuerung parallel geschalteter Leistungshalbleiterschalter zum Schalten eines Gesamtstroms.

### Ausführungsformen der Erfindung:

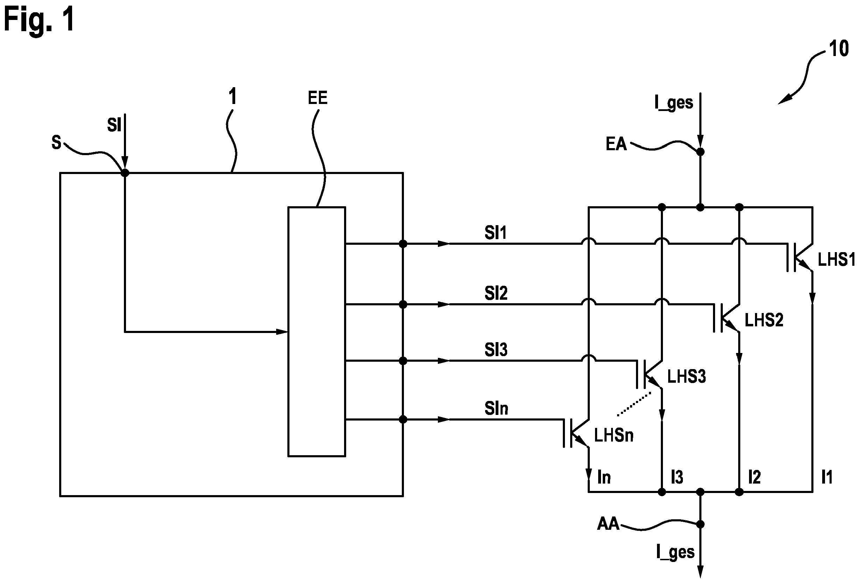

Die Figur 1 zeigt ein elektrisches System 10 in einer schematischen Darstellung. Dem elektrischen System 10 wird ein Gesamtstrom I_ges an einem Eingangsanschluss EA zugeführt. Parallel geschaltete Leistungshalbleiterschalter LHS1..LHSn sind eingangsseitig mit dem Eingangsanschluss EA verbunden und ausgangsseitig mit dem Ausgangsanschluss AA verbunden. Der Gesamtstrom I_ges teilt sich auf die Leistungshalbleiterschalter auf, die geschlossen sind, also den Zustand Schließen aufweisen. Entsprechend entspricht die Summe der Einzelströme I1..In durch die jeweiligen parallel geschalteten Leistungshalbleiter LHS1..LHSn stets dem Gesamtstrom I_ges. Über den Ausgangsanschluss AA wird der Gesamtstrom I_ges abgeleitet. Die parallel geschalteten Leistungshalbleiterschalter LHS1..LHSn dienen sowohl der Stromführung als auch der Unterbrechung des Stromflusses vom Eingangsanschluss EA zum Ausgangsanschluss AA. Die parallel geschalteten Leistungshalbleiterschalter LHS1..LHSn weisen jeweils einen Gate-Anschluss auf. Die Gate-Anschlüsse untereinander sind insbesondere voneinander getrennt. Beispielhaft ist in der Zeichnung dargestellt, dass jeder einzelne Leistungshalbleiterschalter einen einzelnen Gate-Anschluss aufweist. Weiter umfasst das elektrische System 10 ein Steuergerät 1, welches einen gemeinsamen Ansteueranschluss S zur Entgegennahme eines gemeinsamen Ansteuersignals SI aufweist. Das Steuergerät umfasst eine Ermittlungseinheit EE, welcher das Ansteuersignal SI zugeführt wird. Das Ansteuersignal weist die Zustände Öffnen oder Schließen auf. Die Ermittlungseinheit EE ermittelt in Abhängigkeit des Ansteuersignals SI Einzelansteuersignale SI1..SIn. Die Einzelansteuersignale (SI1..SIn) weisen jeweils die Zustände Öffnen oder Schließen auf. Die Einzelansteuersignale SI1..SIn werden von der Ermittlungseinheit EE ausgegeben und an die Gate-Anschlüsse zur Ansteuerung der Leistungshalbleiterschalter übertragen. Vorteilhaft wird somit ermöglicht, das gemeinsame Ansteuersignal SI auf mehrere voneinander unabhängige einzelne Einzelansteuersignale SI1..SIn zu übertragen. So können für die Stromführung des Gesamtstroms I_ges vom Eingangsanschluss EA zum Ausgangsanschluss AA gezielt einzelne oder eine Untermenge der parallel geschalteten Leistungshalbleiterschalter LHS1..LHSn mittels der Einzelansteuersignale SI1..SIn angesteuert und für die Stromführung verwendet werden. Entsprechendes gilt insbesondere auch für die Verwendung von parallel geschalteten Leistungshalbleitermodule anstelle der parallel geschalteten Leistungshalbleiterschalter LHS1..LHSn.

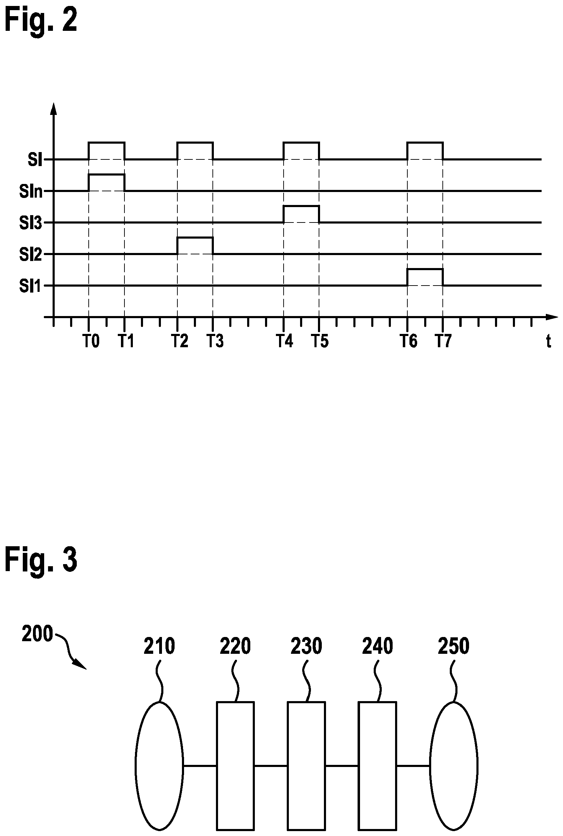

Die Figur 2 zeigt verschiedene Ansteuersignale, die über der Zeitachse t aufgetragen sind. In der obersten Zeile ist das, beispielsweise getaktete, gemeinsame Ansteuersignal SI zu erkennen, welches zwischen den Zeitpunkten T0 und T1, sowie T2 und T3, T4 und T5, und T6 und T7 jeweils den Zustand Schließen und sonst den Zustand Öffnen aufweist. In Abhängigkeit des Ansteuersignals SI ermittelt die Ermittlungseinheit EE Einzelansteuersignale SI1..SIn. Mittels des elektrischen Systems 10 soll zu den Zeitpunkten zu dem das Ansteuersignal SI den Zustand Schließen aufweist der Gesamtstrom I_ges vom Eingangsanschluss zum Ausgangsanschluss geführt werden. In Figur 2 sind weiter beispielhaft die Einzelansteuersignale SI1..SIn für einen alternierenden Betrieb der Leistungshalbleiterschalter LHS1..LHSn dargestellt. So weist das Einzelansteuersignal SIn während des ersten Zustands Schließen des Ansteuersignals SI ebenfalls den Zustand Schließen auf. Somit wird der Leistungshalbleiterschalter LHSn zur Übertragung des Gesamtstroms in diesem Zeitraum angesteuert. Für den zweiten Zeitraum des Zustands Schließen des Ansteuersignals SI wird der zweite Leistungshalbleiterschalter LHS2 verwendet, dessen Einzelansteuersignal SI2 zu diesem Zeitpunkt ebenfalls den Zustand Schließen aufweist. Analog sind der Figur 2 die Zustände und Schaltzeiten des dritten Leistungshalbleiterschalters LHS3 und des ersten Leistungshalbleiterschalters LHS1, sowie die korrespondierenden Einzelansteuersignale SI3 und SI1 zu entnehmen.

Insbesondere ist auch möglich, dass beispielsweise das gemeinsame Ansteuersignal SI durchgehend für einen längeren Zeitraum, beispielsweise zwischen den Zeitpunkten T0 und T7, den Zustand Schließen aufweist und die Einzelansteuersignale SI1..SIn für einen alternierenden Betrieb der Leistungshalbleiterschalter LHS1..LHSn innerhalb dieses Zeitraums entsprechend alternierend den Zustand Schließen aufweisen.

Figur 3 zeigt ein Verfahren 200 zum Ansteuern parallel geschalteter Leistungshalbleiterschalter zum Schalten eines Gesamtstroms I_ges. Im Schritt 210 startet das Verfahren. In Schritt 220 wird das gemeinsame Ansteuersignal SI empfangen. In Schritt 230 werden die Einzelansteuersignale SI1..SIn in Abhängigkeit des Ansteuersignals SI ermittelt. In Schritt 240 werden die Einzelansteuersignale SI1..SIn zur Ansteuerung der Leistungshalbleiterschalter ausgegeben. Mit Schritt 250 endet das Verfahren.

## Patentansprüche

1. Verfahren (200) zum Ansteuern von mindestens zwei parallel geschalteten Leistungshalbleiterschaltern (LHS1..LHSn) zum Schalten eines Gesamtstroms (I_ges),
wobei die mindestens zwei parallel geschalteten Leistungshalbleiterschalter (LHS1..LHSn) jeweils einen Gate-Anschluss zur Ansteuerung des jeweiligen Leistungshalbleiterschalters (LHS1..LHSn) aufweisen,
mit den Schritten:
Bereitstellen eines Eingangsanschlusses (EA) zum Zuführen des Gesamtstroms (I_ges), eines Ausgangsanschlusses (AA) zum Ableiten des Gesamstroms (I_ges) und eines gemeinsamen Ansteueranschlusses (S) zur Entgegennahme eines gemeinsamen Ansteuersignals (SI), welches die Zustände Öffnen oder Schließen aufweist,
wobei die mindestens zwei parallel geschalteten Leistungshalbleiterschalter (LHS1..LHSn) eingangsseitig mit dem Eingangsanschluss (EA) und ausgangsseitig mit dem Ausgangsanschluss (AA) verbunden sind;
Bereitstellen mindestens einer Ermittlungseinheit (EE), die dazu eingerichtet ist, eingangsseitig das gemeinsame Ansteuersignal (SI) zu empfangen und mindestens zwei Einzelansteuersignale (SI1..SIn) in Abhängigkeit des gemeinsamen Ansteuersignals (SI) zur Ansteuerung der mindestens zwei Leistungshalbleiterschalter (LHS1..LHSn) zu ermitteln und ausgangsseitig die mindestens zwei ermittelten Einzelansteuersignale an die jeweiligen Gate-Anschlüsse der mindestens zwei Leistungshalbleiterschalter auszugeben,
wobei die mindestens zwei Einzelansteuersignale (SI1..SIn) jeweils die Zustände Öffnen oder Schließen aufweisen und sich die mindestens zwei Einzelansteuersignale (SI1..SIn) mindestens zeitweise unterscheiden,
**dadurch gekennzeichnet dass** die Belastung der Leistungshalbleiterschalter (LHS1..LHSn) bestimmt wird und die Ermittlung eines Einzelansteuersignals (SI1..SIn) in Abhängigkeit der jeweiligen Belastung des anzusteuernden Leistungshalbleiterschalters (LHS1..LHSn) erfolgt,
wobei zur Bestimmung einer Belastung eines Leistungshalbleiterschalters (LHS1..LHSn) dessen Temperatur, dessen Verlustleistung, dessen übertragene Energiemenge oder dessen Schalthäufigkeit berücksichtigt wird, und
wobei die Ermittlung eines Einzelansteuersignals (SI1..SIn) in Abhängigkeit einer kumulierten Belastung über die gesamten Betriebszeit eines oder einer Untermenge der parallel geschalteten Leistungshalbleiterschalter erfolgt (LHS1..LHSn).

2. Verfahren nach einem der vorhergehenden Ansprüche,
wobei die Ermittlung der Einzelansteuersignale (SI1..SIn) derart in Abhängigkeit des Ansteuersignals (SI) erfolgt, dass während das Ansteuersignal (SI) den Zustand Schließen aufweist, mindestens ein erstes der Einzelansteuersignale (SI1..SIn) den Zustand Öffnen aufweist.

3. Verfahren nach Anspruch 2,
wobei die Ermittlung der Einzelansteuersignale (SI1..SIn) derart in Abhängigkeit des Ansteuersignals (SI) erfolgt, dass während das Ansteuersignal (SI) den Zustand Öffnen aufweist, alle Einzelansteuersignale (SI1..SIn) den Zustand Öffnen aufweisen und während das Ansteuersignal (SI) anschließend den Zustand Schließen aufweist, mindestens ein zweites Einzelansteuersignal (SI1..SIn) den Zustand Öffnen aufweist.

4. Verfahren nach Anspruch 3,
wobei die Ermittlung der Einzelansteuersignale (SI1..SIn) derart in Abhängigkeit des Ansteuersignals (SI) erfolgt, dass bei aufeinanderfolgenden Zuständen Schließen des Ansteuersignals (SI) abwechselnd alternierend unterschiedliche Einzelansteuersignale (SI1..SIn) die Zustände Öffnen aufweisen.

5. Verfahren nach einem der vorhergehenden Ansprüche,
wobei ein Einzelansteuersignal (SI1..SIn) den Zustand Schließen aufweist,
wenn es einen Leistungshalbleiterschalter (LHS1..LHSn) ansteuert, dessen Belastung geringer als ein vorgebbarer Belastungsschwellwert ist.

6. Verfahren nach einem der vorhergehenden Ansprüche,
wobei die Funktionsfähigkeit der Leistungshalbleiterschalter (LHS1..LHSn) bestimmt wird und ein Einzelansteuersignal (SI1..SIn) den Zustand Schließen aufweist, wenn es einen funktionsfähigen Leistungshalbleiterschalter ansteuert (LHS1..LHSn).

7. Verfahren nach einem der vorhergehenden Ansprüche,
wobei als parallel geschaltete Leistungshalbleiterschalter (LHS1..LHSn) mindestens teilweise parallel geschaltete Leistungshalbleitermodule verwendet werden, wobei ein Leistungshalbleitermodul parallel geschaltete Leistungshalbleiterschalter umfasst.

8. Steuergerät (1) zum Ansteuern von mindestens zwei parallel geschalteten Leistungshalbleiterschaltern (LHS1..LHSn) zum Schalten eines Gesamtstroms (I_ges),
wobei die mindestens zwei parallel geschalteten Leistungshalbleiterschalter (LHS1..LHSn) jeweils einen Gate-Anschluss zur Ansteuerung des jeweiligen Leistungshalbleiterschalters (LHS1..LHSn) aufweisen und der Gesamtstrom (I_ges) über einen Eingangsanschluss (EA) zugeführt und über einen Ausgangsanschluss (AA) abgeleitet wird und die mindestens zwei parallel geschalteten Leistungshalbleiterschalter (LHS1..LHSn) eingangsseitig mit dem Eingangsanschluss (EA) und ausgangsseitig mit dem Ausgangsanschluss (AA) verbunden sind;
umfassend einen gemeinsamen Ansteueranschlusses (S) zur Entgegennahme eines gemeinsamen Ansteuersignals (SI), welches die Zustände Öffnen oder Schließen aufweist,
und mindestens eine Ermittlungseinheit (EE), die dazu eingerichtet ist, das gemeinsame Ansteuersignal (SI) zu empfangen und mindestens zwei Einzelansteuersignale (SI1..SIn) in Abhängigkeit des gemeinsamen Ansteuersignals (SI) zur Ansteuerung der mindestens zwei Leistungshalbleiterschalter (LHS1..LHSn) zu ermitteln und ausgangsseitig die mindestens zwei ermittelten Einzelansteuersignale an die jeweiligen Gate-Anschlüsse der mindestens zwei Leistungshalbleiterschalter auszugeben;
wobei die mindestens zwei Einzelansteuersignale (SI1..SIn) jeweils die Zustände Öffnen oder Schließen aufweisen und sich die mindestens zwei Einzelansteuersignale (SI1..SIn) mindestens zeitweise unterscheiden, **dadurch gekennzeichnet dass** die Belastung der Leistungshalbleiterschalter (LHS1..LHSn) bestimmt wird und die Ermittlung eines Einzelansteuersignals (SI1..SIn) in Abhängigkeit der jeweiligen Belastung des anzusteuernden Leistungshalbleiterschalters (LHS1..LHSn) erfolgt,
wobei zur Bestimmung einer Belastung eines Leistungshalbleiterschalters (LHS1..LHSn) dessen Temperatur, dessen Verlustleistung, dessen übertragene Energiemenge oder dessen Schalthäufigkeit berücksichtigt wird, und
wobei die Ermittlung eines Einzelansteuersignals (SI1..SIn) in Abhängigkeit einer kumulierten Belastung über die gesamten Betriebszeit eines oder einer Untermenge der parallel geschalteten Leistungshalbleiterschalter erfolgt (LHS1..LHSn).

9. Elektrisches System (10), umfassend ein Steuergerät (1) gemäß Anspruch 8 und parallel geschaltete Leistungshalbleiterschalter (LHS1..LHSn) zum Schalten eines Gesamtstroms (I_ges) innerhalb eines Fahrzeuges.

10. Computerprogramm, umfassend Befehle, die bewirken, dass das Steuergerät (1) des Anspruchs 8 die Verfahrensschritte nach Anspruch 1-7 ausführt.

11. Elektronisches Speichermedium, auf dem das Computerprogramm nach Anspruch 10 gespeichert ist.

## Claims

1. Method (200) for controlling at least two power semiconductor switches (LHS1..LHSn) connected in parallel for switching a total current (I_tot),
wherein the at least two power semiconductor switches (LHS1..LHSn) connected in parallel each have a gate terminal for controlling the respective power semiconductor switch (LHS1..LHSn),
comprising the following steps:
providing an input terminal (EA) for feeding the total current (I_tot), an output terminal (AA) for conducting away the total current (I_tot) and a common control terminal (S) for receiving a common control signal (SI) having the states open or close,
wherein the at least two power semiconductor switches (LHS1..LHSn) connected in parallel are connected to the input terminal (EA) on the input side and to the output terminal (AA) on the output side;
providing at least one ascertaining unit (EE) configured to receive the common control signal (SI) on the input side and to ascertain at least two individual control signals (SI1..SIn) depending on the common control signal (SI) for controlling the at least two power semiconductor switches (LHS1..LHSn) and, on the output side, to output the at least two individual control signals ascertained to the respective gate terminals of the at least two power semiconductor switches,
wherein the at least two individual control signals (SI1..SIn) each have the states open or close and the at least two individual control signals (SI1..SIn) differ at least at times,
**characterized in that** the loading of the power semiconductor switches (LHS1..LHSn) is determined and ascertaining an individual control signal (SI1..SIn) is carried out depending on the respective loading of the power semiconductor switch (LHS1..LHSn) to be controlled,
wherein in order to determine a loading of a power semiconductor switch (LHS1..LHSn), the temperature thereof, the power loss thereof, the transmitted quantity of energy thereof or the switching frequency thereof is taken into account, and
wherein ascertaining an individual control signal (SI1..SIn) is carried out depending on a cumulated loading over the entire operating time of one or of a subset of the power semiconductor switches connected in parallel (LHS1..LHSn).

2. Method according to any of the preceding claims, wherein ascertaining the individual control signals (SI1..SIn) is carried out depending on the control signal (SI) in such a way that while the control signal (SI) has the state close, at least one first of the individual control signals (SI1..SIn) has the state open.

3. Method according to Claim 2,
wherein ascertaining the individual control signals (SI1..SIn) is carried out depending on the control signal (SI) in such a way that while the control signal (SI) has the state open, all the individual control signals (SI1..SIn) have the state open, and while the control signal (SI) subsequently has the state close, at least one second individual control signal (SI1..SIn) has the state open.

4. Method according to Claim 3,
wherein ascertaining the individual control signals (SI1..SIn) is carried out depending on the control signal (SI) in such a way that in the case of successive states close of the control signal (SI), alternately different individual control signals (SI1..SIn) have the states open in an alternating manner.

5. Method according to any of the preceding claims, wherein an individual control signal (SI1..SIn) has the state close if it controls a power semiconductor switch (LHS1..LHSn) whose loading is lower than a predefinable loading threshold value.

6. Method according to any of the preceding claims, wherein the functionality of the power semiconductor switches (LHS1..LHSn) is determined and an individual control signal (SI1..SIn) has the state close if it controls a functional power semiconductor switch (LHS1..LHSn).

7. Method according to any of the preceding claims, wherein at least partly parallel-connected power semiconductor modules are used as power semiconductor switches (LHS1..LHSn) connected in parallel, wherein a power semiconductor module comprises power semiconductor switches connected in parallel.

8. Control device (1) for controlling at least two power semiconductor switches (LHS1..LHSn) connected in parallel for switching a total current (I_tot), wherein the at least two power semiconductor switches (LHS1..LHSn) connected in parallel each have a gate terminal for controlling the respective power semiconductor switch (LHS1..LHSn), and the total current (I_tot) is fed via an input terminal (EA) and is conducted away via an output terminal (AA), and the at least two power semiconductor switches (LHS1..LHSn) connected in parallel are connected to the input terminal (EA) on the input side and to the output terminal (AA) on the output side;
comprising a common control terminal (S) for receiving a common control signal (SI) having the states open or close,
and at least one ascertaining unit (EE) configured to receive the common control signal (SI) and to ascertain at least two individual control signals (SI1..SIn) depending on the common control signal (SI) for controlling the at least two power semiconductor switches (LHS1..LHSn) and, on the output side, to output the at least two individual control signals ascertained to the respective gate terminals of the at least two power semiconductor switches;
wherein the at least two individual control signals (SI1..SIn) each have the states open or close and the at least two individual control signals (SI1..SIn) differ at least at times,
**characterized in that** the loading of the power semiconductor switches (LHS1..LHSn) is determined and ascertaining an individual control signal (SI1..SIn) is carried out depending on the respective loading of the power semiconductor switch (LHS1..LHSn) to be controlled,
wherein in order to determine a loading of a power semiconductor switch (LHS1..LHSn), the temperature thereof, the power loss thereof, the transmitted quantity of energy thereof or the switching frequency thereof is taken into account, and
wherein ascertaining an individual control signal (SI1..SIn) is carried out depending on a cumulated loading over the entire operating time of one or of a subset of the power semiconductor switches connected in parallel (LHS1..LHSn).

9. Electrical system (10), comprising a control device (1) according to Claim 8 and power semiconductor switches (LHS1..LHSn) connected in parallel for switching a total current (I_tot) within a vehicle.

10. Computer program comprising instructions which cause the control device (1) of Claims 8 to perform the method steps according to Claims 1-7.

11. Electronic storage medium on which the computer program according to Claim 10 is stored.

## Revendications

1. Procédé (200) pour commander au moins deux commutateurs à semi-conducteurs de puissance (LHS1..LHSn) montés en parallèle destinés à commuter un courant total (l_ges),
dans lequel lesdits au moins deux commutateurs à semi-conducteurs de puissance (LHS1..LHSn) montés en parallèle présentent chacun une borne de grille pour la commande du commutateur à semi-conducteurs de puissance (LHS1..LHSn) respectif,
comportant les étapes consistant à :
prévoir une borne d'entrée (EA) pour l'amenée du courant total (l_ges), une borne de sortie (AA) pour la fourniture en sortie du courant total (l_ges) et une borne de commande commune (S) pour la réception d'un signal de commande commun (SI) qui présente les états ouvert et fermé,
dans lequel lesdits au moins deux commutateurs à semi-conducteurs de puissance (LHS1..LHSn) montés en parallèle sont reliés à la borne d'entrée (EA) côté entrée et à la borne de sortie (AA) côté sortie ;
prévoir au moins une unité de détermination (EE) qui est conçue pour recevoir le signal de commande commun (SI) côté entrée et pour déterminer, en réponse au signal de commande commun (SI), au moins deux signaux de commande individuels (SI1..SIn) destinés à commander lesdits au moins deux commutateurs à semi-conducteurs de puissance (LHS1..LHSn), et pour délivrer côté sortie lesdits au moins deux signaux de commande individuels déterminés aux bornes de grille respectives desdits au moins deux commutateurs à semi-conducteurs de puissance,
dans lequel lesdits au moins deux signaux de commande individuels (SI1..SIn) présentent respectivement les états ouvert ou fermé et lesdits au moins deux signaux de commande individuels (SI1..SIn) sont au moins temporairement différents,
**caractérisé en ce que** la charge des commutateurs à semi-conducteurs de puissance (LHS1..LHSn) est déterminée et **en ce que** la détermination d'un signal de commande individuel (SI1..SIn) en fonction de la charge respective du commutateur à semi-conducteurs de puissance (LHS1..LHSn) devant être commandé est effectuée,
dans lequel, pour la détermination d'une charge d'un commutateur à semi-conducteurs de puissance (LHS1..LHSn), sa température, sa perte de puissance, sa quantité d'énergie transmise ou sa fréquence de commutation est prise en compte, et
dans lequel la détermination d'un signal de commande individuel (SI1..SIn) est effectuée en fonction d'une charge cumulée sur toute la durée de fonctionnement d'un ou d'un sous-ensemble des commutateurs à semi-conducteurs de puissance (LHS1..LHSn) montés en parallèle.

2. Procédé selon l'une des revendications précédentes, dans lequel la détermination des signaux de commande individuels (SI1..SIn) est effectuée en réponse au signal de commande (SI) de telle manière que, pendant que le signal de commande (SI) présente l'état fermé, au moins un premier des signaux de commande individuels (SI1..SIn) présente l'état ouvert.

3. Procédé selon la revendication 2,
dans lequel la détermination des signaux de commande individuels (SI1..SIn) est effectuée en réponse au signal de commande (SI) de telle manière que, pendant que le signal de commande (SI) présente l'état ouvert, tous les signaux de commande individuels (SI1..SIn) présentent l'état ouvert et que, pendant que le signal de commande (SI) présente ensuite l'état fermé, au moins un second signal de commande individuel (SI1..SIn) présente l'état ouvert.

4. Procédé selon la revendication 3,
dans lequel la détermination des signaux de commande individuels (SI1..SIn) est effectuée en réponse au signal de commande (SI) de telle manière que, lors d'états de fermeture successifs du signal de commande (SI), différents signaux de commande individuels (SI1..SIn) présentent alternativement les états ouverts.

5. Procédé selon l'une des revendications précédentes, dans lequel un signal de commande individuel (SI1..SIn) présente l'état fermé lorsqu'il commande un commutateur à semi-conducteurs de puissance (LHS1..LHSn) dont la charge est inférieure à une valeur de seuil de charge pouvant être prédéterminée.

6. Procédé selon l'une des revendications précédentes, dans lequel l'aptitude au fonctionnement des commutateurs à semi-conducteurs de puissance (LHS1.LHSn) est déterminée et en ce qu'un signal de commande individuel (SI1..SIn) présente l'état fermé lorsqu'il commande un commutateur à semi-conducteurs de puissance (LHS1..LHSn) apte à fonctionner.

7. Procédé selon l'une des revendications précédentes, dans lequel des modules à semi-conducteurs de puissance au moins partiellement montés en parallèle sont utilisés en tant que commutateurs à semi-conducteurs de puissance (LHS1..LHSn) montés en parallèle, dans lequel un module à semi-conducteurs de puissance comprend des commutateurs à semi-conducteurs de puissance montés en parallèle.

8. Appareil de commande (1) pour commander au moins deux commutateurs à semi-conducteurs de puissance (LHS1..LHSn) montés en parallèle destinés à commuter un courant total (l_ges),
dans lequel lesdits au moins deux commutateurs à semi-conducteurs de puissance (LHS1..LHSn) montés en parallèle présentent chacun une borne de grille pour la commande du commutateur à semi-conducteurs de puissance (LHS1..LHSn) respectif, et le courant total (l_ges) est amené par l'intermédiaire d'une borne d'entrée (EA) et est fourni en sortie par l'intermédiaire d'une borne de sortie (AA), et lesdits au moins deux commutateurs à semi-conducteurs de puissance (LHS1..LHSn) montés en parallèle sont reliés à la borne d'entrée (EA) côté entrée et à la borne de sortie (AA) côté sortie ;
comprenant une borne de commande commune (S) pour la réception d'un signal de commande commun (SI) présentant les états ouvert ou fermé,
et au moins une unité de détermination (EE) qui est conçue pour recevoir le signal de commande commun (SI) et pour déterminer, en réponse au signal de commande commun (SI), au moins deux signaux de commande individuels (SI1..SIn) destinés à commander lesdits au moins deux commutateurs à semi-conducteurs de puissance (LHS1..LHSn), et pour délivrer côté sortie lesdits au moins deux signaux de commande individuels déterminés aux bornes de grille respectives desdits au moins deux commutateurs à semi-conducteurs de puissance ;
dans lequel lesdits au moins deux signaux de commande individuels (SI1..SIn) présentent respectivement les états ouvert ou fermé et lesdits au moins deux signaux de commande individuels (SI1..SIn) sont au moins temporairement différents,
**caractérisé en ce que** la charge des commutateurs à semi-conducteurs de puissance (LHS1..LHSn) est déterminée et **en ce qu'**un signal de commande individuel (SI1..SIn) est déterminé en fonction de la charge respective du commutateur à semi-conducteurs de puissance (LHS1..LHSn) devant être commandé,
dans lequel, pour la détermination d'une charge d'un commutateur à semi-conducteurs de puissance (LHS1..LHSn), sa température, sa dissipation de puissance, sa quantité d'énergie transmise ou sa fréquence de commutation est prise en compte, et
dans lequel la détermination d'un signal de commande individuel (SI1..SIn) est effectuée en fonction d'une charge cumulée sur toute la durée de fonctionnement d'un ou d'un sous-ensemble des commutateurs à semi-conducteurs de puissance (LHS1..LHSn) montés en parallèle.

9. Système électrique (10), comprenant un appareil de commande (1) selon la revendication 8 et des commutateurs à semi-conducteurs de puissance (LHS1..LHSn) montés en parallèle pour la commutation d'un courant total (l_ges) dans un véhicule.

10. Programme d'ordinateur comprenant des instructions amenant l'appareil de commande (1) selon la revendication 8 à exécuter les étapes selon les revendications 1-7.

11. Support de stockage électronique sur lequel est stocké le programme d'ordinateur selon la revendication 10.
